# EUROPÄISCHE PATENTSCHRIFT

(11) **EP 2 191 702 B1**
(45) Veröffentlichungstag und Bekanntmachung des Hinweises auf die Patenterteilung: **08.04.2015**
(21) Anmeldenummer: 08774864.6
(22) Anmeldetag: 08.07.2008
(51) Int. Cl.: H05K 3/04

(54) **VERFAHREN ZUM HEIßPRÄGEN MINDESTENS EINER LEITERBAHN AUF EIN SUBSTRAT SOWIE SUBSTRAT MIT MINDESTENS EINER LEITERBAHN**
METHOD FOR THE HOT EMBOSSING OF AT LEAST ONE CONDUCTOR TRACK ONTO A SUBSTRATE AND SUBSTRATE COMPRISING AT LEAST ONE CONDUCTOR TRACK
PROCÉDÉ D'ESTAMPAGE À CHAUD D'AU MOINS UNE PISTE CONDUCTRICE SUR UN SUBSTRAT, ET SUBSTRAT PRÉSENTANT AU MOINS UNE PISTE CONDUCTRICE

(30) Priorität: 06.09.2007 DE 102007042411
(43) Veröffentlichungstag der Anmeldung: 02.06.2010
(73) Patentinhaber: Robert Bosch GmbH, 70442 Stuttgart (DE)
(72) Erfinder: EHRENPFORDT, Ricardo, 70437 Stuttgart (DE); MAY, Johanna, 70839 Gerlingen (DE)
(86) Internationale Anmeldenummer: PCT/EP2008/058818
(87) Internationale Veröffentlichungsnummer: WO 2009/033842

(56) Entgegenhaltungen:
- DE-A1- 19 738 589
- FR-A- 2 674 724
- US-A- 3 628 243
- US-A1- 2007 049 130

## Beschreibung

### Stand der Technik

Die Erfindung betrifft ein Verfahren zum Heißprägen gemäß dem Oberbegriff des Anspruchs 1 sowie ein Substrat gemäß Anspruch 12.

Das Heißprägen von Leiterbahnen auf, insbesondere aus einem Polymermaterial ausgebildete, Substrate stellt eine umweltfreundliche Möglichkeit zur Herstellung von Leiterbahnen dar. Bei bekannten Heißprägeverfahren wird zunächst das Substrat mit der gewünschten Mikrostruktur, beispielsweise mittels eines Spritzgussverfahrens, hergestellt. Daraufhin wird das Substrat zusammen mit einer auf dieses aufgelegte Metallfolie in eine Presse gelegt, woraufhin die Leiterbahnen unter Anwendung von Druck und Temperatur mittels eines strukturierten Prägestempels als vertiefte Strukturen geprägt werden. Die Restfolie auf einer erhabenen Strukturebene des Substrats wird nach dem Prägeprozess von dem Substrat wieder abgezogen. Der Abziehprozess ist äußerst kritisch. Der Erfolg des Abziehprozesses ist im Wesentlichen abhängig von der Reißfestigkeit der Metallfolie. Nicht abgezogene Folienreste können zu Kurzschlüssen zwischen den Leiterbahnen führen. Beim Abziehprozess können insbesondere dann, wenn der Prägedruck nicht ausreichend groß war, die eigentlichen, von der erhabenen Strukturebene beabstandeten, abgesetzten Leiterbahnen mit abgezogen oder beschädigt werden. Beim Abziehprozess darf also einerseits die (erhabene), abzuziehende Restfolie nicht zu stark an das Substrat angedrückt werden, was zur Folge hat, dass auch die abgesetzten, tiefer gelegenen Leiterbahnen nur mit dieser Maximalkraft aufgebracht werden. Andererseits muss die Prägekraft jedoch ausreichend groß gewählt werden, um zu gewährleisten, dass die Leiterbahnen nach dem Abziehprozess der Restfolie ausreichend stark an dem Substrat anhaften.

Nachteilig bei dem bekannten Verfahren ist weiterhin, dass die Leiterbahnen ausschließlich in einer abgesetzten Strukturebene eingebracht werden können. Dies führt dazu, dass das Festlegen von Halbleiterchips auf den Leiterbahnen mittels eines Klebe-FlipChip-Verfahrens nur möglich ist, wenn die Höhendifferenz zwischen den Leiterbahnen und der erhabenen Strukturebene die Höhe der Bumps unterschreitet. Bei Gold-Stud-Bumps beträgt diese Höhe etwa 50 *µ*m. Dies ist technologisch schwer erzielbar, da bei derartig geringen Prägetiefen aufgrund einer Mindestdicke der zum Einsatz kommenden Metallfolie praktisch keine Stanzung der Metallfolie möglich ist und somit keine Leiterbahnen auf dem Substrat stehen bleiben können. Auch für einen Löt-FlipChip-Prozess sind bekannte Substrate mit eingeprägten Leiterbahnen nur bedingt einsetzbar, da die Lot-Bumps kugelförmig sind und somit für schmale Leiterbahnen nur geringe Prägetiefen akzeptabel wären.

### Offenbarung der Erfindung

Aus der DE 197 38 589 A1 ist eine Leiterplatte mit einem isolierenden Trägersubstrat und einer Leiterbahnstruktur bekannt, die aus einem leitenden Folienmaterial hergestellte Leiterbahnen aufweist. Das Trägersubstrat weist im Zwischenbereich zwischen den Leiterbahnen Vertiefungen auf , wobei im Bereich der Vertiefungen leitendes Folienmaterial vorgesehen ist. Die Struktur des Trägersubstrats wird durch einen Prägevorgang erzeugt. Eine Kupferfolie ist hierbei mittels einer Klebstoffschicht auf eine Oberfläche des Trägersubstrats befestigt.

### Technische Aufgabe

Der Erfindung liegt die Aufgabe zugrunde, ein alternatives, zuverlässigeres Verfahren zum Heißprägen mindestens einer Leiterbahn auf ein insbesondere aus Kunststoff bestehendes Substrat vorzuschlagen. Bevorzugt sollen die mit einem derartigen Verfahren mit mindestens einer Leiterbahn versehenen Substrate für das Aufbringen von Halbleiterbauelementen mittels eines FlipChip-Verfahrens geeignet sein. Ferner besteht die Aufgabe darin, ein entsprechend optimiertes Substrat mit mindestens einer aufgeprägten Leiterbahn herzustellen.

### Technische Lösung

Diese Aufgabe wird hinsichtlich des Verfahrens mit den Merkmalen des Anspruchs 1 gelöst. Vorteilhafte Weiterbildungen der Erfindungen sind in den Unteransprüchen angegeben. In den Rahmen der Erfindung fallen auch sämtliche Kombinationen aus zumindest zwei von in der Beschreibung, den Ansprüchen und/oder den Figuren offenbarten Merkmalen. Zur Vermeidung von Wiederholungen sollen rein vorrichtungsgemäß offenbarte Merkmale als verfahrensgemäß offenbart gelten und beanspruchbar sein. Ebenso sollen rein verfahrensgemäß offenbarte Merkmale als vorrichtungsgemäß offenbart gelten und beanspruchbar sein.

Der Erfindung liegt der Gedanke zugrunde, die auf das Substrat mittels eines Prägestempels aufgeprägte, mindestens eine elektrisch leitende Schicht aufweisende, einschichtige oder mehrschichtige Folie nach Beendigung des Prägevorgangs in mindestens zwei beabstandeten Strukturebenen auf dem Substrat zu belassen. Anders ausgedrückt besteht der Kerngedanke der Erfindung darin, auf ein Abziehen der Folie nach dem Prägevorgang (Druck + Temperatur) in mindestens einer erhabenen Strukturebene, zumindest teilweise, vorzugsweise vollständig zu verzichten. Das nach dem Konzept der Erfindung ausgebildete Verfahren führt zu einem Substrat, bei dem in mindestens zwei in Stempelrichtung (Prägerichtung) beabstandeten Strukturebenen elektrisch leitende Folie verbleibt. Hierdurch ist es möglich, die nicht abgezogene, in der erhabenen Strukturebene verbleibende, auf das Substrat aufgeprägte Folie als mindestens eine Leiterbahn zu verwenden. Aufgrund der erhabenen Anordnung dieser Leiterbahn ist die Anwendung von FlipChip-Verfahren zum Festlegen von Halbleiterbauelementen problemlos möglich, da keine Höhenunterschiede überwunden werden müssen. Zusätzlich oder alternativ zu der Verwendung der in der erhabenen Strukturebene angeordneten Folie ist es möglich, die Folie in mindestens einer zu der erhabenen Strukturebene abgesetzten Strukturebene befindliche Folie als mindestens eine Leiterbahn einzusetzen. Bei einer entsprechenden Strukturierung des Substrates und/oder des Prägestempels ist es sogar denkbar, die Folie in mehr als zwei Strukturebenen mittels eines Heißprägevorgangs auf das Substrat aufzubringen, wobei es weiterhin realisierbar ist, sämtliche, in unterschiedlichen Strukturebenen aufgeprägte, Folien (-abschnitte) als jeweils mindestens eine Leiterbahn zu nutzen. Ein weiterer wesentlicher Vorteil des nach dem Konzept der Erfindung ausgebildeten Verfahrens besteht darin, dass die Haftfestigkeit der Leiterbahnen auf dem Substrat ohne Rücksicht auf einen Abziehprozess eingestellt werden kann. Die Temperatur und der Druck beim Prägeprozess können also im Hinblick auf eine optimale Haftung der Folie auf dem Substrat optimiert werden. Es liegt im Rahmen der Erfindung, mindestens eine Leiterbahn auf ein bereits vorstrukturiertes Substrat als auch mindestens eine Leiterbahn auf ein noch nicht strukturiertes, während des Heißprägens (mikro) zu strukturierendes, Substrat aufzubringen.

Von besonderem Vorteil ist eine Ausführungsform des Verfahrens, bei der vollständig auf ein Abziehen der auf das Substrat aufgeprägten Folie nach dem Prägevorgang verzichtet wird.

Von besonderem Vorteil ist eine Ausführungsform, bei der der Abstand zwischen den mindestens zwei, jeweils mit aufzuprägender Folie zu versehenen, Strukturebenen so groß gewählt wird, dass die auf das Substrat aufgeprägte(n) Folie(n) in den beiden Strukturebenen elektrisch voneinander isoliert sind/ist. Der Abstand ist also so groß zu wählen, dass die Folie in der niedrig gelegenen Strukturebene von der Folie in der erhöht liegenden Strukturebene beim Prägevorgang abgeschert wird.

Von. besonderem Vorteil ist eine Ausführungsform, bei der eine Folie eingesetzt wird, bei der die elektrisch leitende Schicht von einer Metallschicht, beispielsweise einer Aluminiumschicht, einer Kupferschicht oder einer Goldschicht gebildet ist.

Von besonderem Vorteil ist eine Ausführungsform, bei der die zum Einsatz kommende Folie, auf der dem Substrat zugewandten Seite, mit mindestens einer Haftschicht versehen ist. Erfindungsgemäß wird eine vergleichsweise mechanisch stark aufgeraute Schicht eingesetzt, um die Haftwirkung zu verbessern. Unmittelbar auf die elektrisch leitende Schicht oder die mechanisch aufgeraute Schicht kann eine zusätzliche Haftschicht, beispielsweise aus Schwarzoxid, oder eine dendritisch behandelte Schicht aufgebracht werden, wodurch eine stärkere mechanische Verzahnung mit der angeschmolzenen Substratoberfläche erreicht wird.

In Weiterbildung der Erfindung ist mit Vorteil vorgesehen, dass, insbesondere auf der dem Substrat abgewandten Seite der Folie, mindestens eine Veredelungsschicht vorgesehen ist. Diese kann beispielsweise aus Zinn ausgebildet sein. Die Veredelungsschicht dient je nach Beschaffenheit dazu, Korrosionserscheinungen vorzubeugen oder um die Lötbarkeit und/oder die Drahtbondbarkeit und/oder die FlipChipbarkeit zu verbessern. Ein weiterer Vorteil des Vorsehens einer Veredelungsschicht auf der Folie besteht darin, dass gegebenenfalls nur die Folie, nicht aber das gesamte, unter Umständen empfindliche Substrat, einen entsprechenden, beispielsweise galvanischen, Veredelungsprozess durchlaufen muss.

Der zum Einsatz kommende Prägestempel und gegebenenfalls auch eine Vorrichtung zum Ausrichten des Prägestempels relativ zu dem Substrat kann beispielsweise aus Messing, Stahl oder Keramik ausgebildet sein. In jedem Fall sollte zumindest die Stempelfläche des Prägestempels aus einem Werkzeugmaterial sein, das härter ist als die zum Einsatz kommende Folie, um den Verschleiß des Prägestempels zu minimieren.

Bei dem eingangs beschriebenen aus dem Stand der Technik bekannten Heißprägeverfahren ist es ferner von Nachteil, dass dieses nur auf einzelne Substrate angewendet werden kann, da das Problem besteht, dass falls eine gemeinsame Folie auf mehrere Substrate gleichzeitig aufgelegt würde, sich diese beim Prägeprozess stark verschieben und Falten werfen würde. Um dieses Problem zu umgehen und um eine gleichzeitige, d.h. parallele Fertigung, d.h. Heißprägung mehrerer Substrate mit einer gemeinsamen Folie, zu ermöglichen, wird vorgeschlagen, die Folie vor und/oder während des Prägevorgangs, zumindest abschnittsweise, auf das mindestens eine, vorzugsweise auf sämtliche zu prägenden Substrate laminiert, d.h. vorfixiert, wird. Zusätzlich oder alternativ kann die Folie über das mindestens eine, vorzugsweise über mehrere Substrate vor und/oder während des gemeinsamen Prägevorgangs, beispielsweise mittels eines Spannrahmens, gespannt werden. Diese hier beschriebenen Lösungen sollen als eigenständige Erfindung offenbart gelten und alleine oder in Kombination mit mindestens einem weiteren in der Anmeldung offenbarten Merkmal beanspruchbar sein, unabhängig davon, ob die Folie nach dem Prägevorgang abgezogen wird oder vorzugsweise (vollständig) auf dem Substrat in mehreren in Stempelrichtung voneinander beabstandeten Strukturebenen verbleibt.

Von besonderem Vorteil ist es (insbesondere nach vorheriger Vorfixierung und/oder vorherigem Spannen einer gemeinsamen Folie auf bzw. über mehrere Substrate), mehrere Substrate gleichzeitig mit mindestens einer Leiterbahn zu prägen. Bevorzugt wird hierzu ein gemeinsamer Prägestempel mit mehreren Prägeabschnitten eingesetzt. Ebenso ist es denkbar, ein großflächiges Substrat in unterschiedlichen Substratabschnitten durch die Laminierung, d.h. Vorfixierung, und/oder das Vorspannen der gemeinsamen Folie gleichzeitig zu prägen, wobei es realisierbar ist, die unterschiedlichen, vorzugsweise gleichartigen, Substratabschnitte nach dem Prägeprozess voneinander zu trennen, um einzelne, vorzugsweise identische, Bauelemente zu erhalten. Das Trennen kann beispielsweise durch Schneiden oder Sägen erfolgen.

Optimiert werden kann das zuvor beschriebene Verfahren dadurch, dass das Substrat gleichzeitig mit dem Aufprägen mindestens einer Leiterbahn mittels des Prägestempels strukturiert wird. Beispielsweise können, insbesondere außerhalb eines von der Folie überdeckten Bereichs, Mikrostrukturen, vorzugsweise fluidische Strukturen, wie Kanäle, Durchgangslöcher, Kavernen, etc. in das vorzugsweise aus Polymer bestehende Substrat eingeprägt werden.

Die Erfindung führt auch auf ein Substrat, vorzugsweise hergestellt mit einem zuvor beschriebenen Verfahren, wobei auf das Substrat mindestens eine Leiterbahn aufgeprägt ist. Das Substrat zeichnet sich dadurch aus, dass in mindestens zwei voneinander beabstandeten Strukturebenen Folie, aufweisend mindestens eine elektrisch leitende Schicht, aufgeprägt ist, wobei es im Rahmen der Erfindung liegt, dass nur die Folie in einer der Strukturebenen als auch die Folie in mindestens zwei Strukturebenen jeweils mindestens eine Leiterbahn bildet. Es ist eine Ausbildung des Substrates mit einer Vielzahl, d. h. mit mehr als zwei mit jeweils einer elektrisch leitenden Folie versehenen Strukturebene denkbar, wobei es möglich ist, dass die Folien in jeder Strukturebene jeweils mindestens eine Leiterbahn bilden.

Bevorzugt ist der Abstand der Strukturebenen voneinander so groß gewählt, dass die Folie in den unterschiedlichen Strukturebenen voneinander getrennt, d.h. elektrisch isoliert, ist.

Bevorzugt ist eine Ausführungsform des Substrates, bei der, sowohl in einer erhabenen Strukturebene als auch in einer von dieser abgesetzten Strukturebene, eine Leiterbahn aufgeprägt ist.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1:: zwei unterschiedliche Polymersubstrate,
- Fig. 2:: ein Ausführungsbeispiel einer möglichen zur Anwendung kommenden Folie,
- Fig. 3:: eine mögliche Ausführungsform eines Prägestempels,
- Fig. 4:: eine Presse, in der ein Substrat mit einer vollflächig auf dieser aufgelegten Folie angeordnet ist,
- Fig. 5:: eine Presse, in der mehrere Substrate angeordnet sind, auf die eine gemeinsame Folie vor dem eigentlichen Prägeschritt auflaminiert wurde,
- Fig. 6:: eine teilflächige Anordnung zweier auf ein einziges Substrat laminierten Folien,
- Fig. 7:: ein in einer Presse aufgenommenes Substrat, auf das zwei beabstandete Folien auflaminiert sind, wobei der Prägestempel auch in einem Bereich außerhalb der Folien zur Strukturierung des Substrates mit einer Prägestruktur versehen ist,
- Fig. 8:: ein aus dem Prägevorgang gemäß Fig. 7 resultierendes, mit Leiterbahnen versehenes, Substrat,
- Fig. 9:: ein Substrat mit in zwei Strukturebenen angeordneten Folienabschnitten, wobei lediglich die in der erhabenen Strukturebene angeordneten Folienabschnitte Leiterbahnen bilden und
- Fig. 10:: ein Substrat, bei dem in zwei unterschiedlichen, voneinander beabstandeten, Strukturebenen Leiterbahnen aus Folienabschnitten aufgeprägt sind.

### Ausführungsformen der Erfindung

In den Figuren sind gleiche Bauteile und Bauteile mit der gleichen Funktion mit den gleichen Bezugszeichen gekennzeichnet.

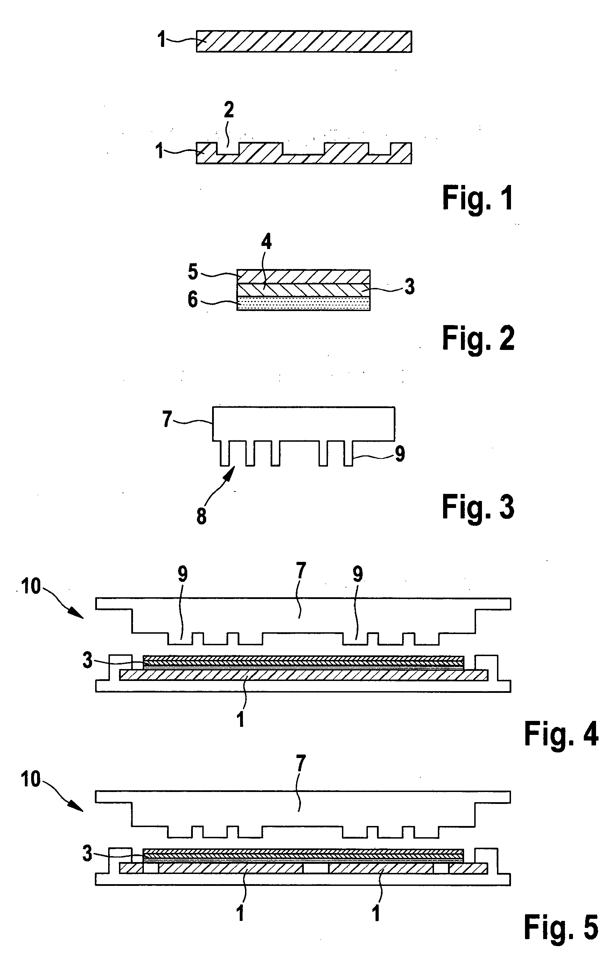

In Fig. 1 sind übereinander zwei unterschiedliche Substrate 1 aus einem Kunststoffmaterial gezeigt. Das in der Zeichnungsebene obere Substrat 1 ist unstrukturiert. Das in der Zeichnungsebene untere Substrat 1 ist mit einer Mikrostruktur 2 versehen, die beispielsweise in einem abtragenden oder in einem Umformverfahren oder beispielsweise im Spritzgussverfahren eingebracht wurde.

In Fig. 2 ist eine mögliche, zum Herstellen von Leiterbahnen zum Einsatz kommende, Folie 3 gezeigt. Die Folie 3 ist in dem gezeigten Ausführungsbeispiel dreischichtig ausgeführt. Eine mittlere, elektrisch leitende, Schicht 4 ist in dem gezeigten Ausführungsbeispiel aus Gold ausgebildet. Darüber befindet sich in der Zeichnungsebene eine Veredelungsschicht 5. Auf einer dem Substrat 1 in einem späteren Prägeprozess zugewandten unteren Seite ist eine Haftschicht 6 vorgesehen.

In Fig. 3 ist ein möglicher, für den Heißprägeprozess notwendiger, Prägestempel 7 mit einer Stempelfläche 8 gezeigt. Die Stempelfläche 8 ist mit einer Prägestruktur 9 (Mikrostruktur) versehen.

In Fig. 4 ist eine Presse 10 mit einem Prägestempel 7 gezeigt. In die Presse ist ein unstrukturiertes Substrat 1 eingelegt. Auf diesem befindet sich eine dreischichtige Folie 3 (vgl. Fig. 3), die entweder nur auf das Substrat 1 aufgelegt, vorzugsweise jedoch auf dieses in einem vorhergehenden Schritt auflaminiert wurde. Alternativ ist das Spannen der Folie 3, beispielsweise in einem Spannrahmen, möglich. Der Prägestempel 7 ist in zwei voneinander beabstandeten Abschnitten mit jeweils einer Prägestruktur 9 versehen. Beim Stempeln (Prägen) werden demnach zwei identisch geprägte Substratabschnitte erhalten, die in einem darauf folgenden Schritt voneinander getrennt werden können.

Bei dem Ausführungsbeispiel gemäß Fig. 5 sind in die Presse 10 mehrere, unterschiedliche, nicht strukturierte Substrate 1 eingelegt, bei denen eine gemeinsame Folie 3 angeordnet ist. Die Folie 3 ist auf sämtliche Substrate 1 auflaminiert. Alternativ ist ein Spannen der Folie 3, beispielsweise in einem Spannrahmen, möglich.

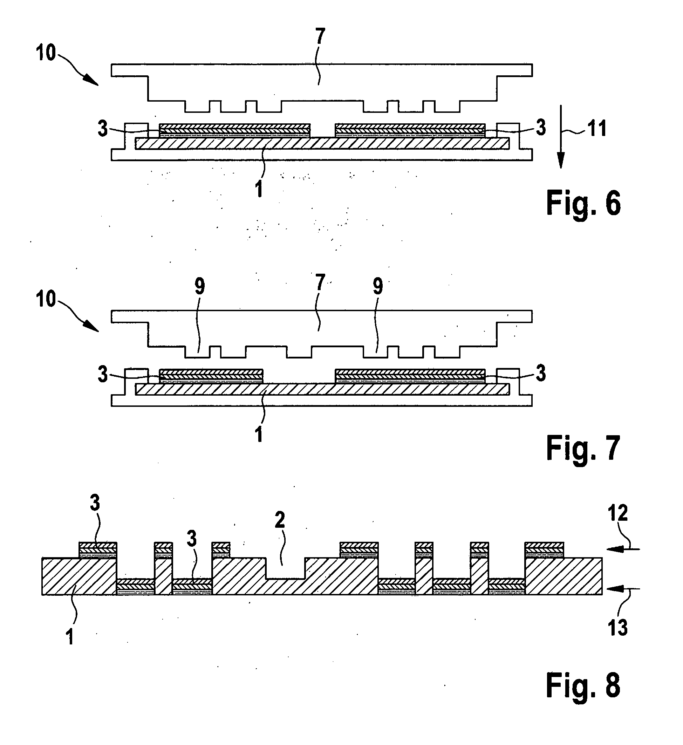

In dem Ausführungsbeispiel gemäß Fig. 6 sind auf einem einzigen, nicht strukturierten, Substrat 1 zwei beabstandete Folien 3 auflaminiert. Durch einen Prägevorgang, bei dem der Prägestempel 7 auf das Substrat 1 in eine Stempelrichtung 11 relativ zu dem Substrat 1 bewegt wird, können zwei identisch strukturierte, d. h. mit jeweils mindestens einer Leiterbahn versehene, Substratabschnitte erhalten werden, die in einem späteren Verfahrensschritt voneinander getrennt werden können.

Bei dem Ausführungsbeispiel gemäß Fig. 7 ist in eine Presse 10 ein einziges, nicht strukturiertes, Substrat 1 eingebracht. Auf dieses sind zwei beabstandete, unterschiedlich große, Folien 3 auflaminiert. Der Prägestempel 7 ist nicht nur in den Bereichen oberhalb der Folien 3 mit einer Prägestruktur 9 versehen, sondern weist auch in einem außerhalb der Folien liegenden Bereich eine Prägestruktur 9 auf, mit der die in Fig. 8 gezeigte Mikrostruktur 2, insbesondere eine fluidische Mikrostruktur 2, in das Substrat 1 einbringbar ist.

In Fig. 8 ist ein aus dem Prägeprozess gemäß Fig. 7 resultierendes Substrat 1 gezeigt. Zu erkennen ist, dass sowohl die Folie 3 in einer erhabenen Strukturebene 12 als auch in einer von dieser abgesetzten Strukturebene 13 auf das Substrat 1 aufgeprägt wurde. Auf ein Abziehen der Folie 3 in der erhabenen Strukturebene 12 wurde erfindungsgemäß verzichtet. Sowohl die Folie 3 bzw. Folienabschnitte in der erhabenen Strukturebene 12 als auch die Folie 3 bzw. Folienabschnitte in der abgesetzten Strukturebene 13 können jeweils mindestens eine Leiterbahn bilden. Der Abstand zwischen den Strukturebenen 12, 13 ist so groß gewählt, dass die Folie 3 in der erhabenen Struktur 12 von der Folie 3 in der abgesetzten Struktur 13 elektrisch isoliert ist (abgescherte Folienabschnitte).

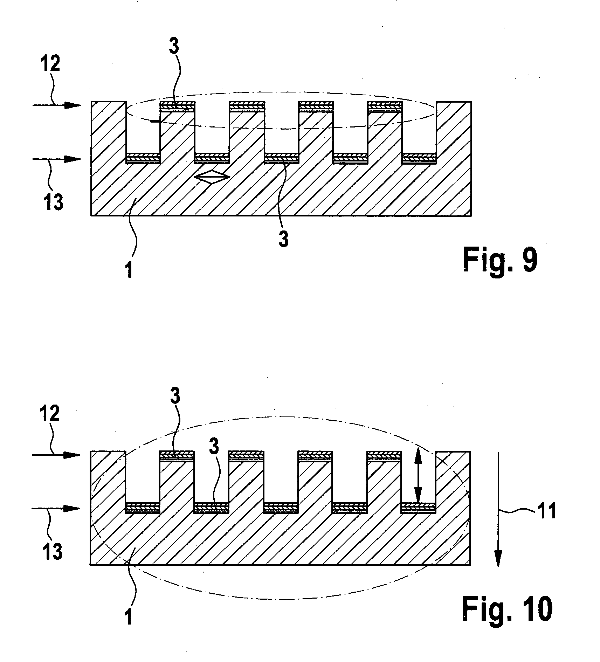

In Fig. 9 ist ein mögliches, mit einem erfindungsgemäßen Verfahren herstellbares, Substrat 1 gezeigt. Zu erkennen ist, dass sowohl in einer erhabenen Strukturebene 12 als auch in einer in Stempelrichtung 11 von dieser beabstandeten, abgesetzten Strukturebene 13, Folie 3 bzw. Folienabschnitte aufgeprägt sind. Die in der erhabenen Strukturebene 12 angeordneten Folienabschnitte (eingekreist) dienen als aktive Leiterbahn(en), während den Folienabschnitten in der abgesetzten Strukturebene 13 keine aktive elektrisch leitende Funktion zukommt. Diese sind von den Folienabschnitten in der erhabenen Strukturebene 12 elektrisch isoliert durch eine entsprechend große Beabstandung der Strukturebenen 12, 13.

Das Ausführungsbeispiel gemäß Fig. 10 entspricht im Wesentlichen dem Ausführungsbeispiel gemäß Fig. 9 mit dem einzigen Unterschied, dass in beiden Strukturebenen 12, 13 angeordnete, aufgeprägte Folienabschnitte aktive Leiterbahnen dienen, was durch die Einkreisung sämtlicher Folienabschnitte symbolisiert ist.

## Patentansprüche

1. Verfahren zum Heißprägen mindestens einer Leiterbahn auf ein Substrat, wobei eine mindestens eine elektrisch leitende Schicht (4) aufweisende Folie (3) mittels eines eine strukturierte Stempelfläche (8) aufweisenden Prägestempels (7) gegen das Substrat (1) in eine Stempelrichtung (11) gepresst wird,wobei die Folie (3) nach Beendigung des Prägevorgangs in mindestens zwei in Stempelrichtung (11) beabstandeten Strukturebenen (12, 13) auf dem Substrat (1) verbleibt, **dadurch gekennzeichnet**,dass eine Folie (3) verwendet wird, bei der zusätzlich zu der elektrisch leitenden Schicht (4) mindestens eine Haftschicht (6) mit einer rauen Struktur, vorgesehen ist.

2. Verfahren nach Anspruch 1, **dadurch gekennzeichnet, dass** auf ein Abziehen der Folie (3) von dem Substrat (1) im Stempelbereich nach dem Prägevorgang verzichtet wird.

3. Verfahren nach einem der Ansprüche 1 oder 2, **dadurch gekennzeichnet, dass** der Abstand zwischen den Strukturebenen (12, 13) so groß gewählt wird, dass die Folie (3) in der erhabenen Strukturebene (12) von der Folie (3) in der abgesetzten Strukturebene (13) elektrisch voneinander isoliert ist.

4. Verfahren nach einem der vorhergehenden Ansprüche, **dadurch gekennzeichnet, dass** eine Folie (3) verwendet wird, bei der die elektrisch leitende Schicht (4) von einer Metallschicht, vorzugsweise von einer Aluminiumschicht, einer Kupferschicht oder einer Goldschicht gebildet ist.

5. Verfahren nach einem der vorhergehenden Ansprüche, **dadurch gekennzeichnet, dass** eine Folie (3) verwendet wird, bei der zusätzlich zu der elektrisch leitenden Schicht (4) mindestens eine Veredelungsschicht (5), insbesondere zum Schutz gegen Korrosion und/oder zum Verbessern der Lötbarkeit und/oder der FlipChipbarkeit und/oder der Drahtbondbarkeit, vorgesehen ist.

6. Verfahren nach einem der vorhergehenden Ansprüche, **dadurch gekennzeichnet, dass** die Folie (3) vor und/oder während des Prägevorgangs, zumindest abschnittsweise, auf das Substrat (1) laminiert wird.

7. Verfahren nach einem der vorhergehenden Ansprüchen, **dadurch gekennzeichnet, dass** die Folie (3) vor und/oder während des Prägevorgangs gespannt wird.

8. Verfahren nach einem der vorhergehenden Ansprüche, **dadurch gekennzeichnet, dass** gleichzeitig auf mehrere, vorzugsweise nebeneinander angeordnete, Substrate (1) oder Substratabschnitte jeweils mindestens eine Leiterbahn geprägt wird.

9. Verfahren nach einem der vorhergehenden Ansprüche, **dadurch gekennzeichnet, dass** zum gemeinsamen Prägen mehrer Substrate (1) eine gemeinsame Folie (3) eingesetzt wird.

10. Verfahren nach Anspruch 9, **dadurch gekennzeichnet, dass** das Substrat (1) mittels des Prägestempels (7), vorzugsweise in Bereichen außerhalb der Folie (3), strukturiert wird.

## Claims

1. Method for the hot embossing of at least one conductor track onto a substrate, wherein a film (3) having at least one electrically conductive layer (4) is pressed against the substrate (1) in an embossing direction (11) by means of an embossing die (7) having a structured die surface (8), wherein the film (3) remains on the substrate (1) after the end of the embossing process in at least two structure planes (12, 13) that are spaced apart in the embossing direction (11), **characterized in that** a film (3) in which at least one adhesive layer (6) with a rough structure is provided in addition to the electrically conductive layer (4) is used.

2. Method according to Claim 1, **characterized in that** the film (3) is not peeled off from the substrate (1) in the area of the die after the embossing process.

3. Method according to either of Claims 1 and 2, **characterized in that** the distance between the structure planes (12, 13) is chosen to be large enough that the film (3) in the raised structure plane (12) is electrically insulated from the film (3) in the recessed structure plane (13).

4. Method according to one of the preceding claims, **characterized in that** a film (3) in which the electrically conductive layer (4) is formed by a metal layer, preferably by an aluminium layer, a copper layer or a gold layer, is used.

5. Method according to one of the preceding claims, **characterized in that** a film (3) in which at least one finishing layer (5), in particular for protecting against corrosion and/or for improving the soldering capability and/or the flip-chip capability and/or the wire-bonding capability, is provided in addition to the electrically conductive layer (4) is used.

6. Method according to one of the preceding claims, **characterized in that** at least certain portions of the film (3) are laminated onto the substrate (1) before and/or during the embossing process.

7. Method according to one of the preceding claims, **characterized in that** the film (3) is stretched before and/or during the embossing process.

8. Method according to one of the preceding claims, **characterized in that** at least one conductor track is respectively embossed onto multiple substrates (1) or substrate portions that are preferably arranged next to one another at the same time.

9. Method according to one of the preceding claims, **characterized in that** a common film (3) is used for the joint embossing of multiple substrates (1).

10. Method according to Claim 9, **characterized in that** the substrate (1) is structured by means of the embossing die (7), preferably in regions outside the film (3).

## Revendications

1. Procédé pour l'estampage à chaud d'au moins une piste conductrice sur un substrat, une feuille (3) présentant au moins une couche électriquement conductrice (4) étant pressée au moyen d'un poinçon d'estampage (7) présentant une surface structurée (8) de poinçon contre le substrat (1) dans un sens (11) du poinçon, la feuille (3) restant sur le substrat (1) après la fin du processus d'estampage dans au moins deux plans de structure (12, 13) écartés dans le sens (11) du poinçon, **caractérisé en ce qu'**on utilise une feuille (3) présentant, en plus de la couche électriquement conductrice (4), au moins une couche adhésive (6) présentant une structure rugueuse.

2. Procédé selon la revendication 1, **caractérisé en ce qu'**on renonce à un retrait de la feuille (3) du substrat (1) dans la zone du poinçon après le processus d'estampage.

3. Procédé selon l'une quelconque des revendications 1 ou 2, **caractérisé en ce que** la dimension de la distance entre les plans (12, 13) de structure est choisie de manière telle que la feuille (3) dans le plan (12) de structure élevé est isolée électriquement de la feuille (3) dans le plan (13) de structure du fond.

4. Procédé selon l'une quelconque des revendications précédentes, **caractérisé en ce qu'**on utilise une feuille (3) dans laquelle la couche électriquement conductrice (4) est formée par une couche métallique, de préférence par une couche d'aluminium, une couche de cuivre ou une couche d'or.

5. Procédé selon l'une quelconque des revendications précédentes, **caractérisé en ce qu'**on utilise une feuille (3) présentant, en plus de la couche électriquement conductrice (4), au moins une couche de revêtement (5), en particulier pour la protection contre la corrosion et/ou pour l'amélioration de l'aptitude au soudage et/ou de l'aptitude à l'utilisation comme puce retournée et/ou de l'aptitude au soudage de fils.

6. Procédé selon l'une quelconque des revendications précédentes, **caractérisé en ce que** la feuille (3) est laminée avant et/ou pendant le processus d'estampage, au moins par sections, sur le substrat (1).

7. Procédé selon l'une quelconque des revendications précédentes, **caractérisé en ce que** la feuille (3) est tendue avant et/ou pendant le processus d'estampage.

8. Procédé selon l'une quelconque des revendications précédentes, **caractérisé en ce qu'**on estampe à chaque fois au moins une piste conductrice simultanément sur plusieurs substrats (1) ou sections de substrats, de préférence disposé(e)s les un(e)s à côté des autres.

9. Procédé selon l'une quelconque des revendications précédentes, **caractérisé en ce qu'**on utilise une feuille (3) commune pour l'estampage commun de plusieurs substrats (1).

10. Procédé selon la revendication 9, **caractérisé en ce que** le substrat (1) est structuré au moyen du poinçon d'estampage (7), de préférence dans des zones en dehors de la feuille (3).
